# EUROPEAN PATENT SPECIFICATION

(11) **EP 2 180 314 B1**
(45) Date of publication and mention of the grant of the patent: **16.09.2015**
(21) Application number: 09174030.8
(22) Date of filing: 26.10.2009
(51) Int. Cl.: G01N 27/327, H01L 29/12, G01F 23/00, G01L 9/00, G01P 15/125, H01L 29/06, B82Y 30/00, B82Y 15/00

(54) **Capacitive Nanowire Sensor**
Kapazitiver Nanodrahtsensor
Capteur à nano-fils capacitive

(30) Priority: 24.10.2008 US 108451 P
(43) Date of publication of application: 28.04.2010
(73) Proprietor: Stichting IMEC Nederland, 5656 AE Eindhoven (NL)
(72) Inventor: Offermans, Peter, 5611 SZ Eindhoven (NL); Crego Calama, Mercedes, 5663 PK Geldrop-Mierlo (NL); Brongersma, Sywert H., 5644 GK Eindhoven (NL)
(74) Representative: Sarlet, Steven Renaat Irène

(56) References cited:
- WO-A2-2008/133656
- KARLSTROM O ET AL: "Analysing the capacitance-voltage measurements of vertical wrapped-gated nanowires" NANOTECHNOLOGY 20081022 INSTITUTE OF PHYSICS PUBLISHING; DIRAC HOUSE GB, vol. 19, no. 43, 22 October 2008 (2008-10-22), XP002559565
- RODDARO STEFANO ET AL: "InAs nanowire metal-oxide-semiconductor capacitors" APPLIED PHYSICS LETTERS, AIP, AMERICAN INSTITUTE OF PHYSICS, MELVILLE, NY, US, vol. 92, no. 25, 27 June 2008 (2008-06-27) , pages 253509-253509, XP012107737 ISSN: 0003-6951
- THELANDER C ET AL: "Nanowire-based one-dimensional electronics" MATERIALS TODAY, ELSEVIER SCIENCE, KIDLINGTON, GB, vol. 9, no. 10, 1 October 2006 (2006-10-01), pages 28-35, XP025174966 ISSN: 1369-7021 [retrieved on 2006-10-01]

## Description

### Technical field of the invention

The invention relates to the field of sensors, more particularly chemical and bio-sensing devices comprising nanowires.

### Description of the related technology

In US2008/0142361 a carbon nanotube (CNT) based gas sensor is described. The CNT gas sensor comprises a substrate, an insulating layer formed on the substrate, electrodes formed on the insulating layer and CNT barriers that protrude higher than the electrodes in spaces between the electrodes to form gas detecting spaces. A gas absorbed to the CNT barriers changes their electrical resistance. The amount of gas is detected based on the measurement of electrical resistance changes. High sensitivity cannot be achieved using this approach.

In WO2007/022359 a vertically integrated silicon nanowire field effect transistor and the fabrication thereof is presented. The field effect transistor according to WO2007/033359 comprises a nanowire extending from a substrate base; a dielectric material surrounding at least a portion of the nanowire; a gate material surrounding at least a portion of the dielectric material, the nanowire having an exposed tip, which is not covered with the dielectric material or the gate material; and a drain material coupled to and in contact with the exposed tip of the nanowire. The transistor does not allow chemical sensing.

Thomas Bryllert et al (in Nanotechnology 17, S227 - S230 (2006) and in IEEE Device Lett. 27, 323-325 (2006)) demonstrate a vertical wrap gated nanowire transistor. This device however does not allow chemical sensing The nanowire surface is covered with a gate dielectric, the gate dielectric being covered with a gate metal.

KARLSTROM O ET AL: "Analysing the capacitance-voltage measurements of vertical wrapped-gated nanowires", NANOTECHNOLOGY, vol. 19, no.43, 22 October 2008, p.435201; RODDARO STEFANO ET AL: "InA nanowire metal-oxide semiconductor capacitors" APPLIED PHYSICS LETTERS, vol. 92, no. 25, 27 June 2008, pages 253509-253509 and THELANDER C ET AL: "Nanowire-based one-dimensional electronics" MATERIALS TODAY, ELSEVIER SCIENCE, KIDLINGTON, GB, vol. 9, no. 10, 1 October 2006 (2006-10-01), pages 28-35 describe modules comprising nanowires with a bottom, an intermediate part and a top, the bottom being closer to the substrate than the top. The module further comprises a surrounding electrode for each nanowire, surrounding the bottom and at least part of the intermediate part of the nanowire in height direction, each surrounding electrode being electrically isolated from the respective nanowire. RODDARO ET AL further describes that measurement circuitry is electrically connected to each nanowire and each surrounding electrode for measuring the capacity. None of the three publications allows chemical sensing.

### Disclosure of the invention

It is an aim of the invention to provide a nanowire-based analyte sensing device having a higher sensitivity.

This aim is achieved with the device showing the technical characteristics of the first independent claim.

An analyte sensing device according to the present invention comprises at least one sensing module on a substrate wherein each sensing module comprises: at least one nanowire, each nanowire comprising a bottom, an intermediate part and a top, the bottom being closer to the substrate than the top; a surrounding electrode for each nanowire, the surrounding electrode surrounding the bottom and at least part of the intermediate part of the nanowire in height direction, each surrounding electrode being electrically isolated from the corresponding nanowire, wherein each surrounding electrode has an inner surface facing an outer surface of the corresponding nanowire;
a functionalization layer provided on at least one of said inner and outer surfaces for binding the at least one analyte to be detected; a gap between each nanowire and the corresponding surrounding electrode for allowing penetration of at least one analyte to be detected between the nanowire and the corresponding surrounding electrode; and measurement circuitry electrically connected to each nanowire and each surrounding electrode for detecting a change in an electrical property, e.g. a change in capacitive coupling between the at least one nanowire and the corresponding surrounding electrode, as a result of said penetration and binding of at least one analyte into said gap.

With the device according to the invention, a higher sensitivity, for example a sensitivity in the range between 100 ppb and 1 ppm, can be achieved as a result of using the capacitive coupling between the nanowire and the surrounding electrode as a basis for the measurement. Further advantages of embodiments of the invention can be one or more of the following: low power consumption for example in the range between 5 microWatt and 100 microWatt or between 10 microWatt and 40 microWatt, a shorter response time, and good selectivity. Furthermore, the analyte sensing device according to the invention can be operated at room temperature such that the need for heating can be avoided.

In embodiments of the device of the invention, the nanowires can be substantially orthogonal to the substrate, i.e. a longitudinal direction of the nanowires can form an angle close to 90° with the plane of the substrate surface. In embodiments of the present invention, the angle between the longitudinal direction of the nanowires and the plane of the substrate surface can be in the range between 80° and 90°, e.g. in the range between 85° and 90°. The surrounding electrodes may be provided on an insulating layer on the substrate. The nanowires can for example be made from a material or an alloy of materials selected from the group consisting of Si, Ge, InAs, GaAs, InP, InN, GaN, ZnO, In₂O₃, WO₃.

The gap between a nanowire and the corresponding surrounding electrode can have a width between 5 nm and 500 nm, between 10 nm and 100 nm, between 50 nm and 100 nm.

The surrounding electrodes can for example be made from a material selected from the group consisting of Cr, Cu, Au, Pt, Ti, Ta, Ru, Ni, Ge, Al, Mo, conducting Si.

A functionalization layer can be provided on both said inner and outer surfaces. A first functionalization layer on the outer surface of the nanowires can be provided for binding a first analyte and a second functionalization layer can be provided on the inner surface of the surrounding electrodes for binding a second analyte.

The functionalization layer can for example be selected from the group consisting of thiolslinkers, carbohydroxilic acid linkers, amine-based linkers, self-assembled molecules, porphyrins, phthalocyanines, polymers, metaloxides and metals.

The measurement circuitry may comprise at least one nanowire measurement pad in electrical contact with the top and/or the bottom of each nanowire. It may comprise a bottom nanowire measurement pad electrically connected to the bottom of each nanowire and/or it may comprise a top nanowire measurement pad electrically connected to the top of each nanowire. It may comprise a surrounding electrode measurement pad in electrical contact with each surrounding electrode. The measurement circuitry may be provided for detecting a capacitance change between each nanowire and the corresponding surrounding electrode. The measurement circuitry may be provided for detecting a change in electrical current through each nanowire while the corresponding surrounding electrode is operated as a transistor gate.

A sensing device according to the present invention may comprise a plurality of sensing modules arranged in an array, each sensing module being electrically isolated from the other sensing modules. The different sensing modules may comprise different functionalization layers being selected to sense different analytes.

Each sensing module may comprise a plurality of nanowires being in electrical contact with each other and with the nanowire measurement pads.

In a sensing device according to the present inveniton the bottom and/or the top of the nanowires can be doped such as to realise an Ohmic contact with the measurement circuitry. The intermediate part of the nanowires may be doped such as to modify to sensing performance.

### Brief description of the drawings

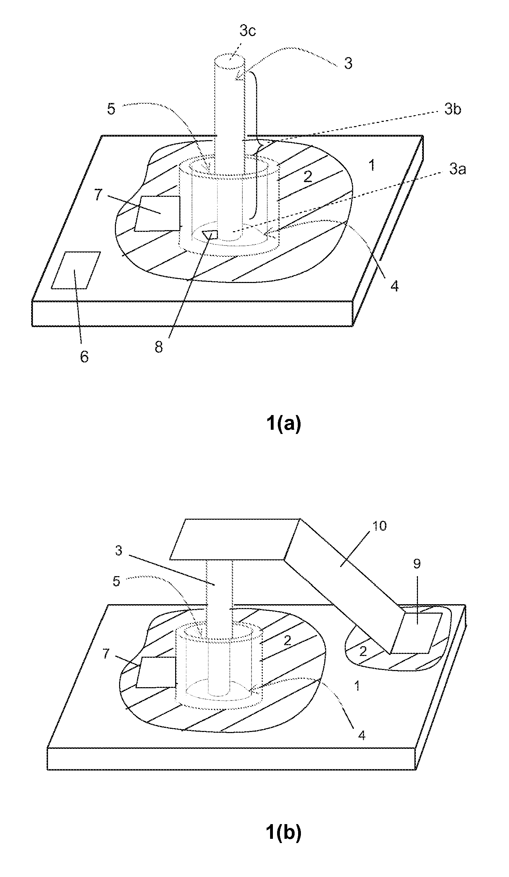

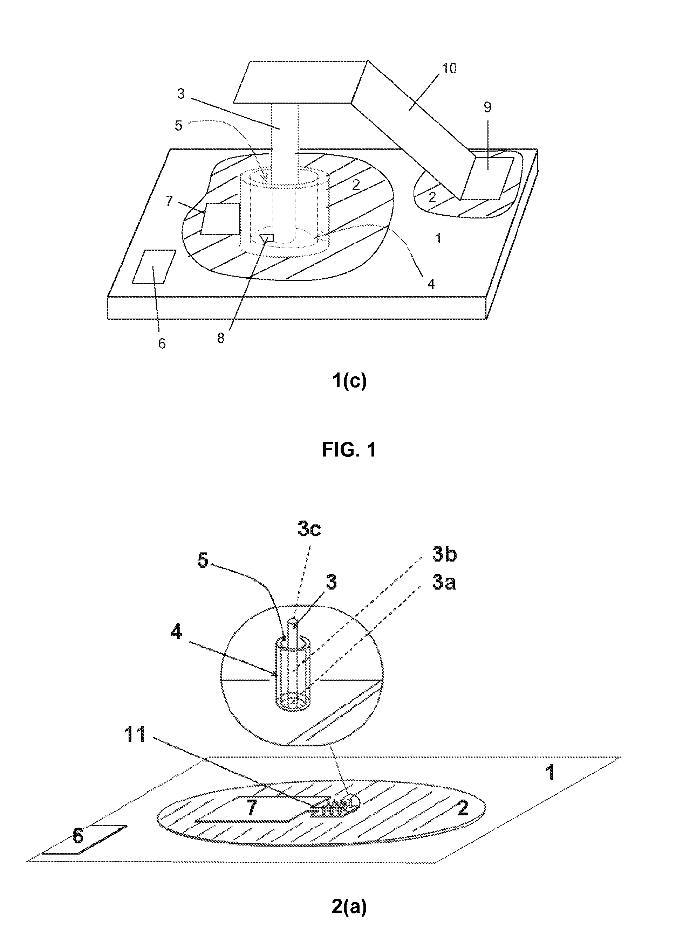

Figures 1(a), 1(b) and 1(c) schematically illustrate nanowire-based sensing elements according to the present invention, showing one nanowire with surrounding electrode and: Fig. 1(a) an electrical contact only to the bottom of the nanowire, Fig. 1(b) an electrical contact only to the top of the nanowire; Fig. 1(c) an electrical contact both to the top and bottom of the nanowire

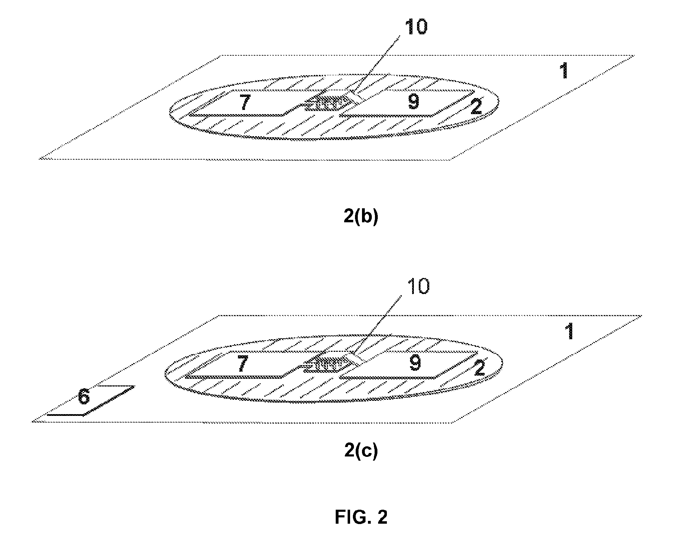

Figures 2(a), 2(b) and 2(c) schematically illustrate nanowire-based sensing modules according to the present invention, the sensing modules comprising a plurality of nanowires with surrounding electrode and: Fig. 2(a) an electrical contact only to the bottom of the nanowires, Fig. 2(b) an electrical contact only to the top of the nanowires; Fig. 2(c) an electrical contact both to the top and bottom of the nanowires.

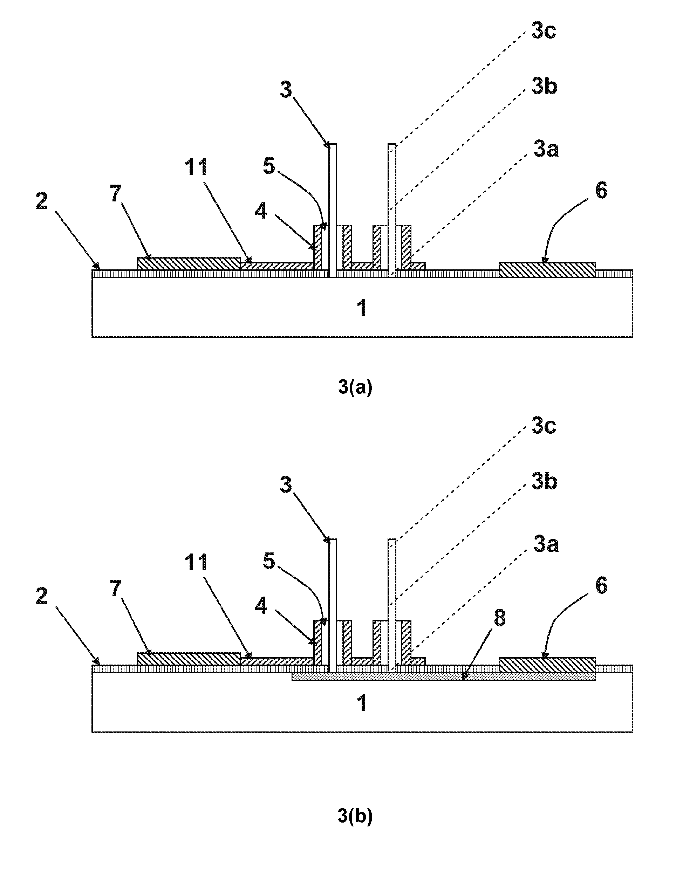

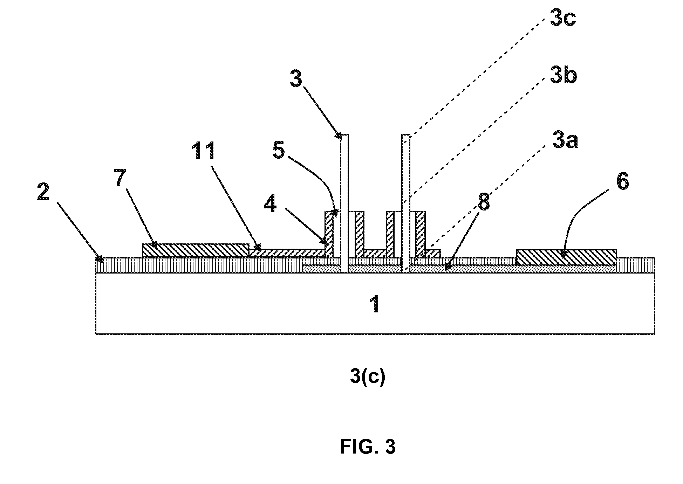

Figures 3(a), 3(b) and 3(c) show a cross section of a sensing module with a surrounding electrode and an electrical contact to the bottom of the nanowires: Fig. 3(a) with the nanowires in electrical contact with the (semi)conducting substrate; Fig 3(b) with the nanowires in electrical contact with a conducting region realized in the substrate; Fig. 3(c) with the nanowires in electrical contact with a conducting region realized on the substrate.

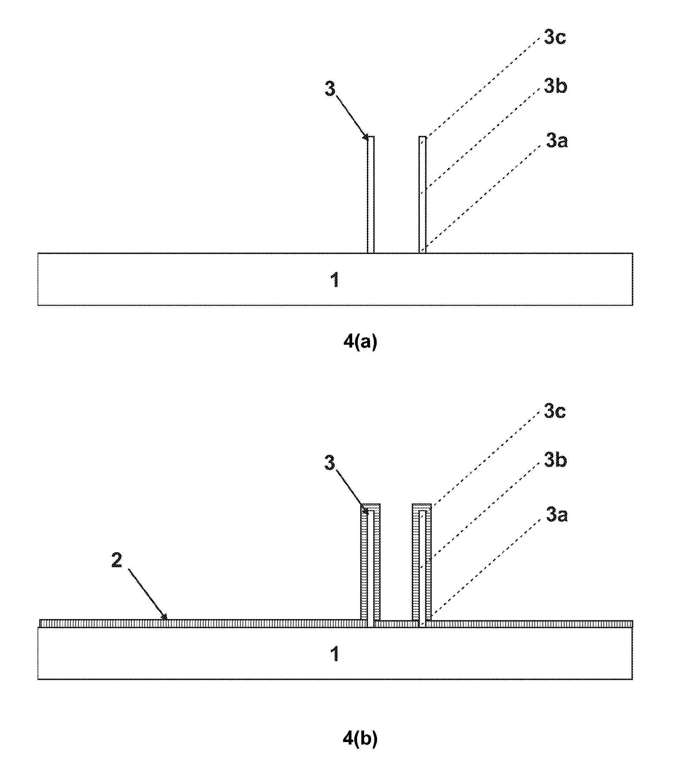

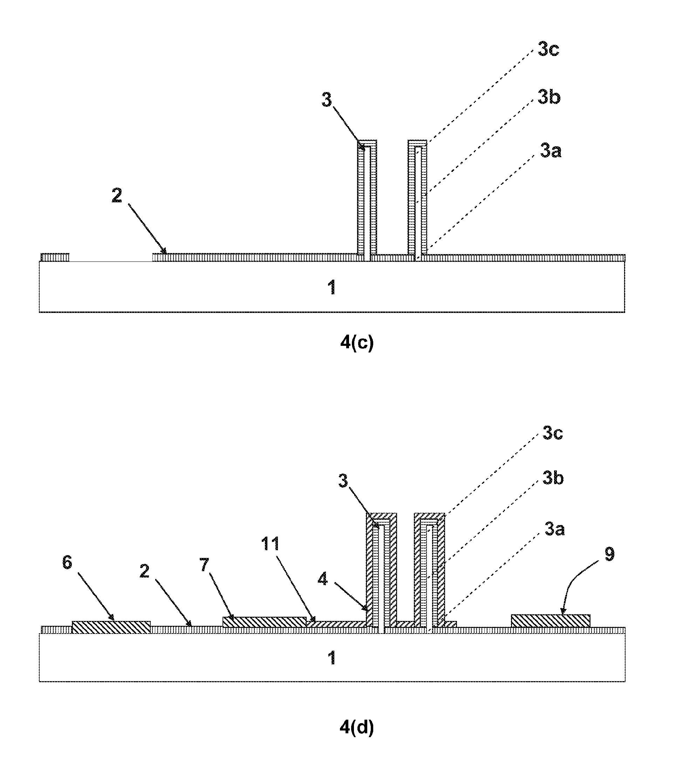

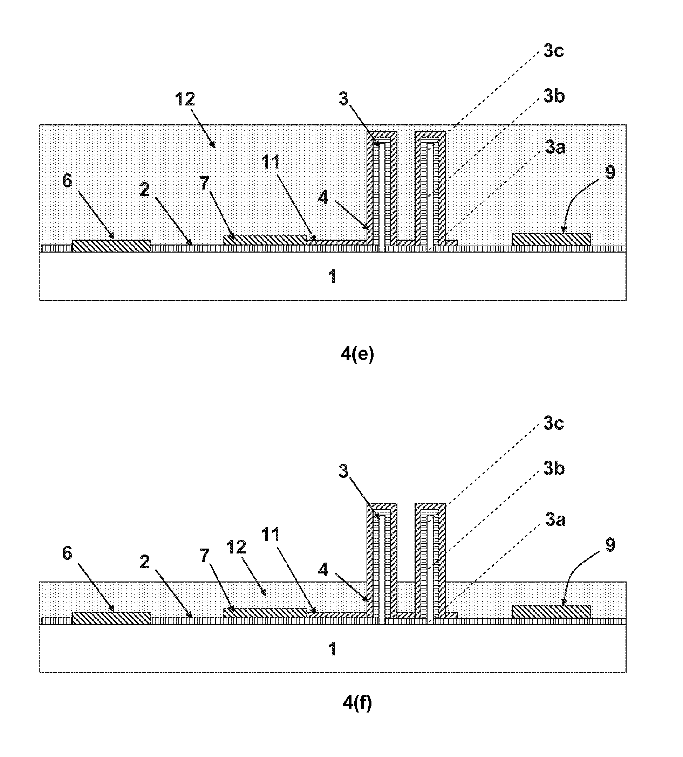

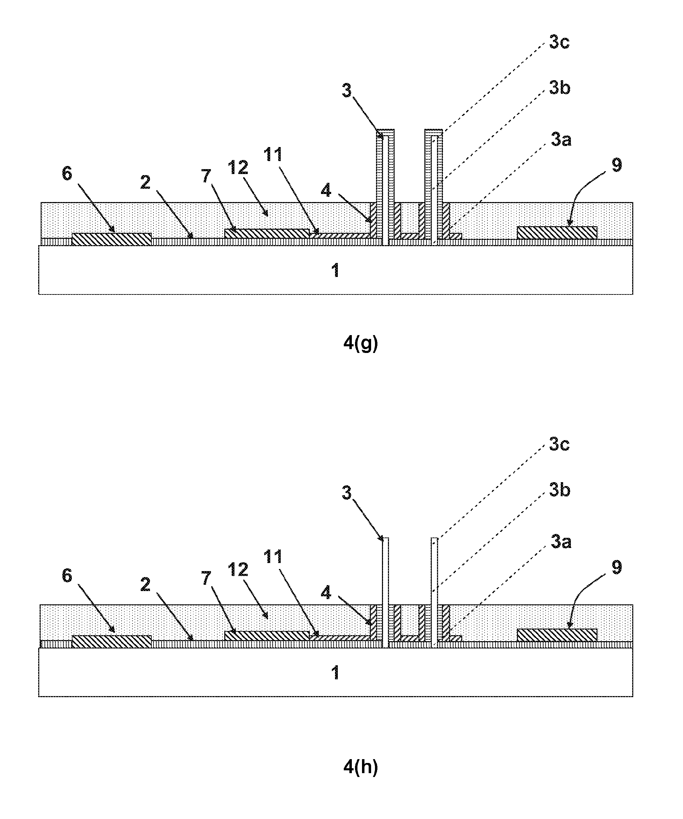

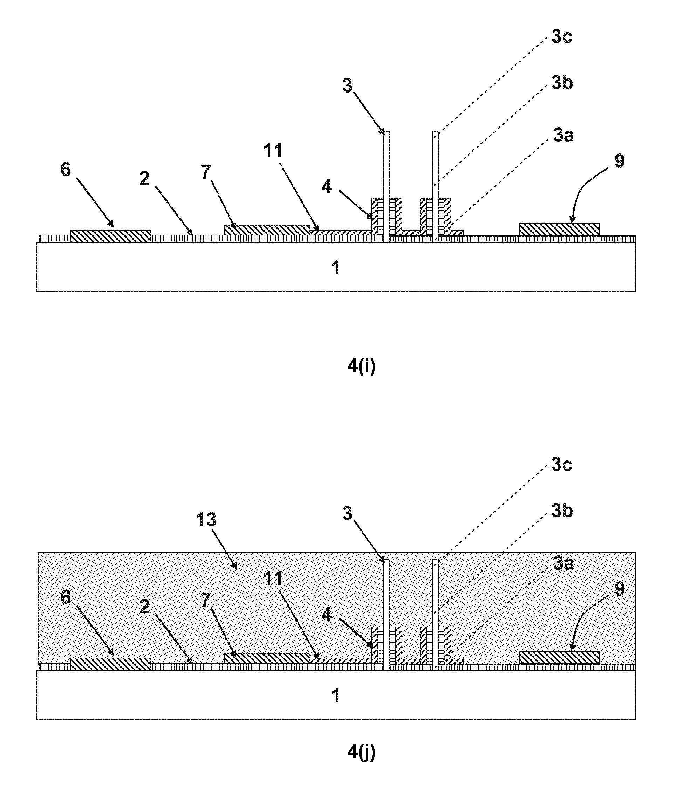

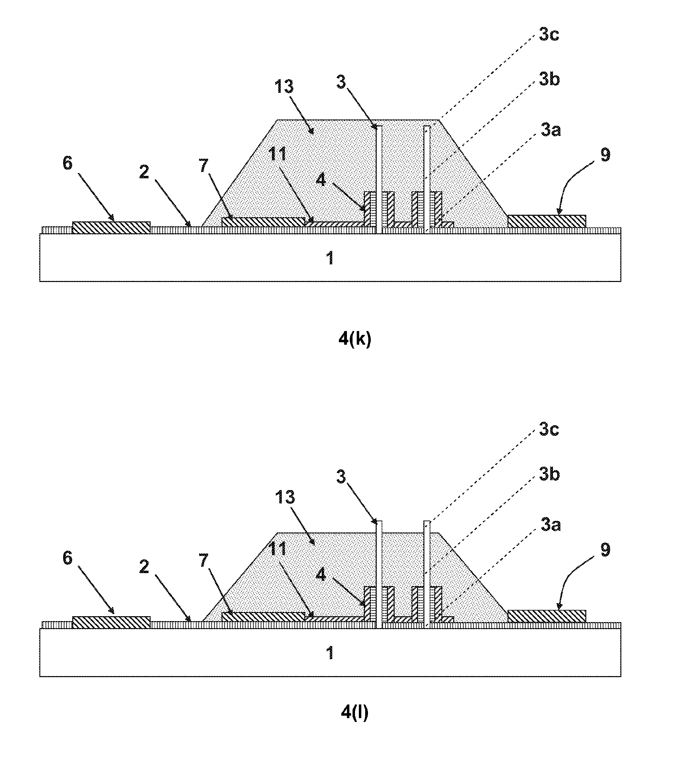

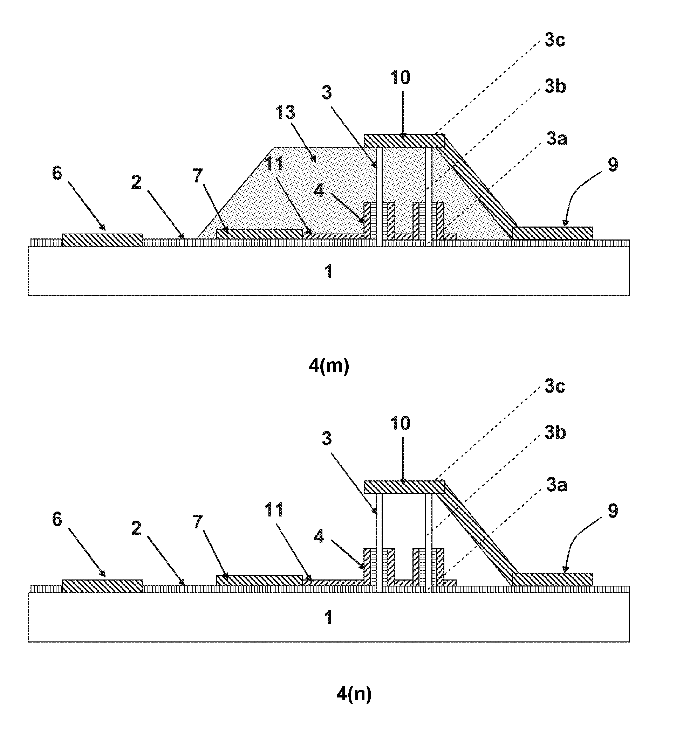

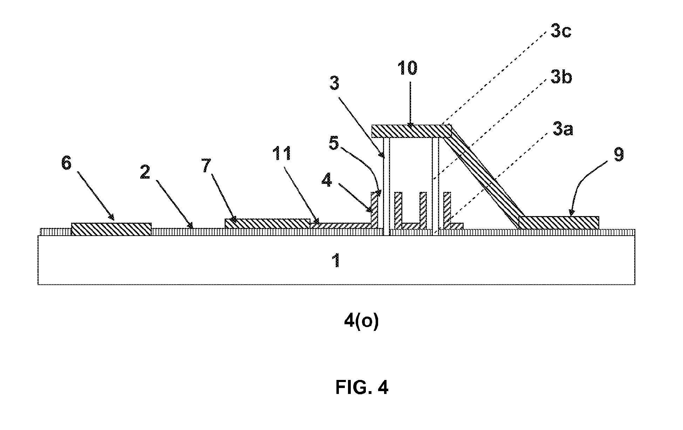

Figure 4 illustrates a fabrication process for a nanowire, surrounding electrode, insulating surface, and top and bottom electrodes to the nanowire.

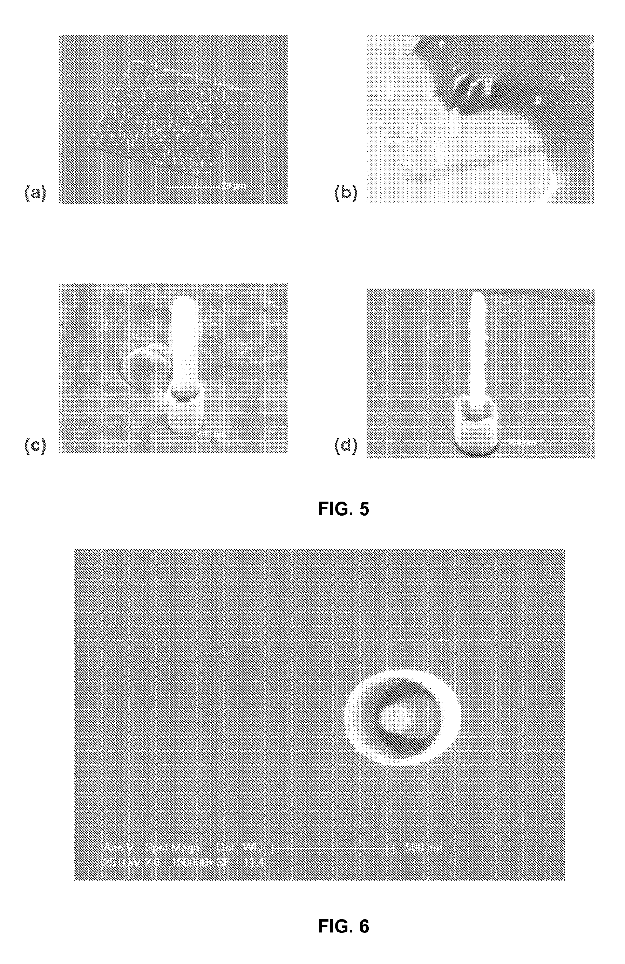

Figures 5(a) shows a SEM picture of an array of nanowires; Figure 5(b) shows a SEM picture of nanowires with surrounding electrodes; Figure 5(c) is a SEM picture of a nanowire with surrounding electrode; and Figure 5(d) is a SEM picture of a nanowire with surrounding electrode where the gap between nanowire and surrounding electrode is clearly visible.
Figure 6 is a top view SEM picture of a sensing element wherein the air gap between nanowire and surrounding electrode is clearly visible. The surrounding electrode has the same height as the nanowire.

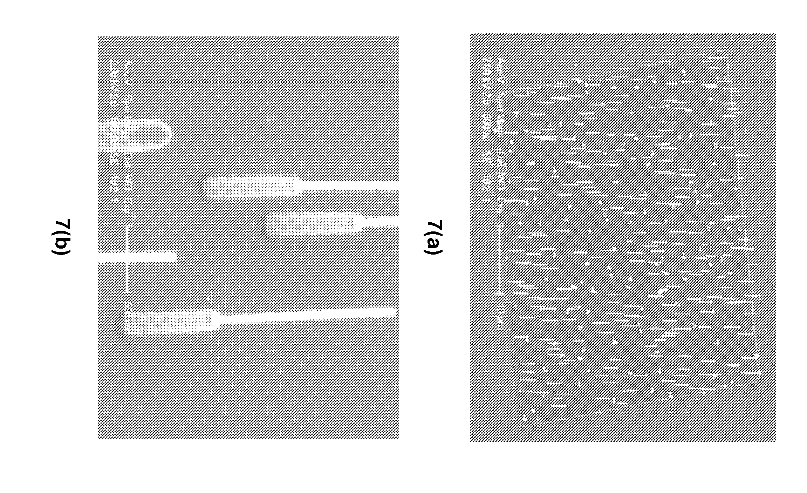

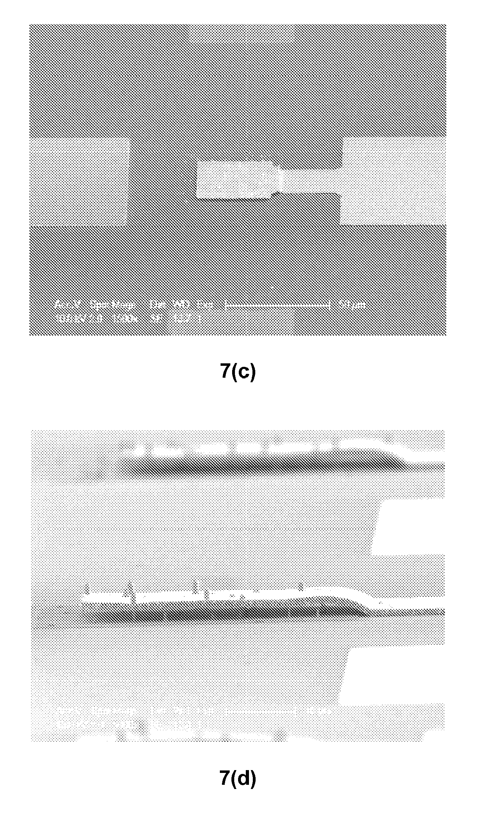

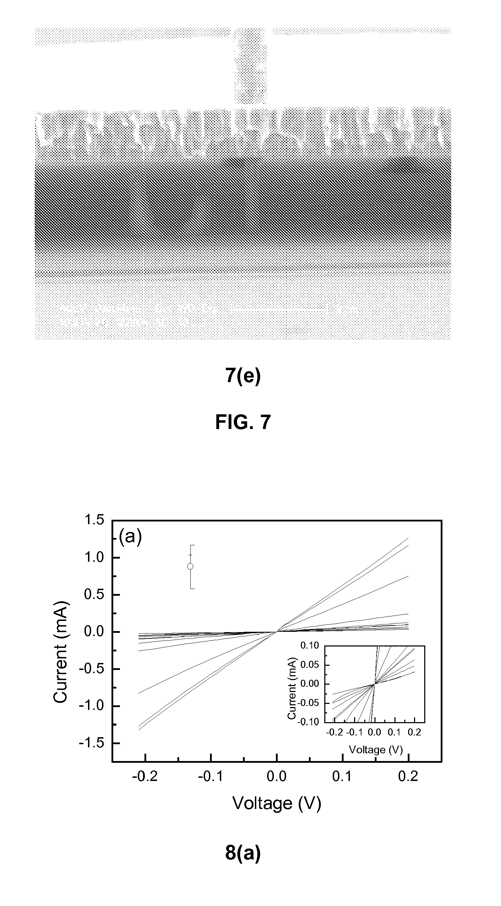

Figure 7 shows SEM images of: Figure 7(a) patterned vertical nanowire arrays; Figure 7(b) nanowires partially embedded in a silicon nitride isolation layer; Figure 7(c) airbridge contacts to vertical nanowire arrays; Figure 7(d) and Figure 7(e) side views of vertically connected nanowire arrays.

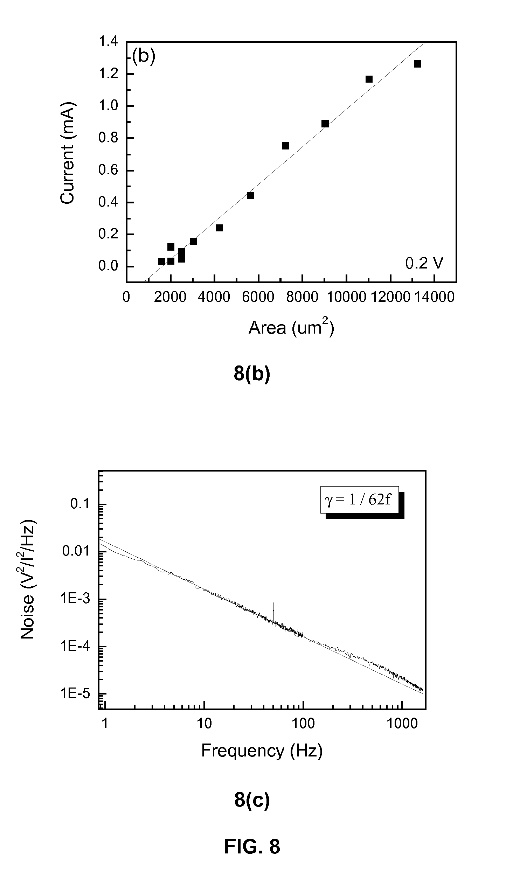

Figure 8(a) shows IV curves measured on pairs of nanowire arrays, indicating Ohmic contacts. Figure 8(b) illustrates scaling of the current with the contacted area. Figure 8(c) shows the noise spectral density per unit Hz measured between pairs of nanowire arrays each consisting of about 200 nanowires.

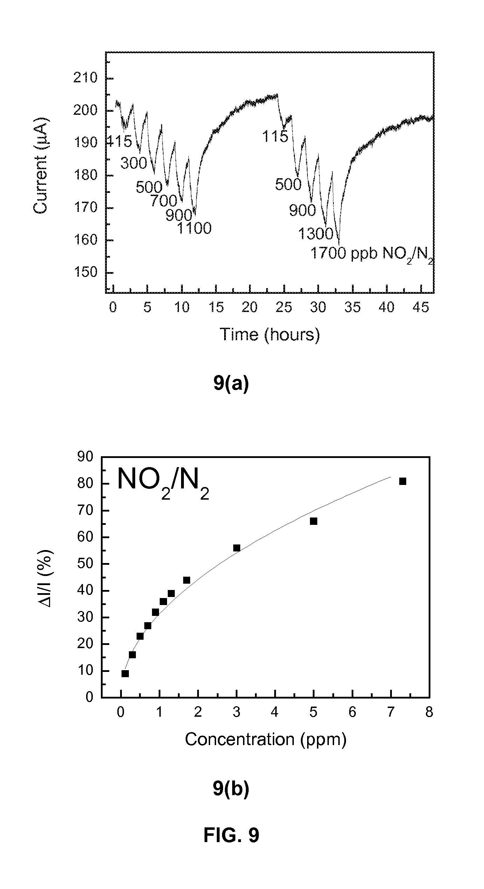

Figure 9(a) shows the current measured between pairs of nanowire arrays in an NO₂/N₂ environment. Figure 9(b) shows the response for varying concentrations of NO₂ in N₂ using 1 hour exposure intervals.

### Preferred modes for carrying out the invention

Nanowire-based devices are promising as a new sensor generation due to their large surface-to-volume ratio which may lead to shorter response times and larger sensitivity.

The present invention provides an analyte sensing device, wherein the sensing device comprises vertical semiconductor nanowires with a surrounding electrode. The analyte sensing device according to the present invention can be used for detecting analytes such as inorganic gases, organic vapors, biomolecules, viruses and the like.., based on the measurement of a change in the capacitive coupling between the nanowires and their surrounding electrode. Surfaces of a sensing device of the present invention are functionalized, e.g. for the detection of a specific analyte (inorganic gases, organic vapors, biomolecules, virus and the like..,). The sensing device can have low power consumption, short response time, high sensitivity, and high selectivity. The device can be operated at room temperature such that the need for heating the device (and the corresponding power consumption) can be avoided, It can have small dimensions, leading to a high packing density. The power consumption can for example be in the order of a few tens of microwatts. The sensitivity, e.g. to NO₂, can be lower than 1 ppm, e.g. in the range between 100 ppb and 1 ppm.

Figures 1(a), 1(b) and 1(c) schematically illustrate nanowire-based sensing elements according to embodiments of the present invention. These Figures only show a single nanowire with a surrounding electrode, but in practical devices an array of nanowires with corresponding surrounding electrodes can be used. A sensing element comprises a nanowire 3 that is in electrical contact with at least one electrical contact pad or nanowire measurement pad 6, 9 (bottom nanowire measurement pad 6 and/or top nanowire measurement pad 9), for example via first electrical connections (bottom electrical connection or bottom electrode 8 and top electrical connection or top electrode 10). The nanowire comprises a bottom 3a, an intermediate or centre part 3b and a top 3c. In the context of the present invention the bottom 3a of the nanowire is the part of the nanowire closest to the substrate, the top 3c is the part of the nanowire at the largest distance from the substrate, and the intermediate part 3b is the elongated part in between the bottom and the top. Furthermore a surrounding electrode 4 is surrounding at least part of the intermediate part 3b of the nanowire in height direction. This surrounding electrode 4 can be electrically connected to a surrounding electrode measurement pad 7, optionally via second electrical connections 11. The device comprises a gap 5 between the nanowire 3 and the surrounding electrode 4. The device comprises at least one electrode or electrical connection 8, 10 to the nanowire 3. As illustrated in Figure 1(a), in embodiments of the present invention only a bottom electrode or bottom electrical connection 8 to the nanowire 3 can be present, wherein the bottom electrode 8 electrically connects the bottom 3a of the nanowire with a bottom nanowire measurement pad 6. Figure 1(b) illustrates an embodiment wherein only a top electrode or top electrical connection 10 to the nanowire 3 is present, wherein the top electrode 10 electrically connects the top 3c of the nanowire with a top nanowire measurement pad 9. In other embodiments there may be more than one electrical connection to the nanowire 3, for example (as illustrated in Figure 1(c)) a top electrode or top electrical connection 10 (electrically connecting the top 3c of the nanowire with a top nanowire measurement pad 9) and a bottom electrode or bottom electrical connection 8 (electrically connecting the bottom 3a of the nanowire with a bottom nanowire measurement pad 6).

The working principle of the device is based on the concept that an analyte penetrating in the gap 5 between the nanowire 3 and the surrounding electrode 4 changes the capacitive coupling between the nanowire 3 and the surrounding electrode 4, for example due to the presence of an analyte in the gap or due to charge/energy transfer from the analyte to the nanowire 3 and/or the surrounding electrode 4. Providing a functionalization layer on the nanowire outer surface and/or the inner surface of the surrounding electrode can increase the sensitivity of the device.

The nanowire measurement pads 6, 9 and the surrounding electrode measurement pad 7 are further connected to and are part of measurement circuitry (not illustrated) for detecting a capacitive coupling change, resulting from penetration of an analyte into the gap 5.

For sensing applications, a plurality of nanowires (each with a corresponding surrounding electrode) can be electrically connected to form a sensing module. This may increase the measurement signal and/or increase the signal-to-noise ratio. Three-dimensional images of examples of sensing modules are schematically shown in Figure 2. The sensing module comprises at least one (preferably a plurality of) vertical nanowires 3, each nanowire being surrounded by a surrounding electrode 4 on a substrate 1, with a gap 5 between the surrounding electrode 4 and the nanowire 3. The nanowire 3 and the surrounding electrode 4 are electrically isolated from each other. The nanowires can be connected by means of electrical connections or electrodes 8, 10 to nanowire measurement pads 6, 9. The surrounding electrodes 4 can be electrically connected by means of a second electrical connection 11 to a surrounding electrode measurement pad 7.

One or more of those sensing modules (Figure 2) can be located on the substrate. Several sensing modules, being connected independently, can be used as independent sensing modules. These sensing modules can be essentially the same or can be different. They can be arranged in a matrix structure on the substrate in order to increase selectivity by finger-print type of sensing and/or multiparametric detection of one or multiple analytes.

Examples of substrates 1 that may be used in embodiments of the present invention are: SiN, AIO, SiC, Si, III/V compounds such as InP, GaAs, GaP, implanted Si, Si partially or fully covered with silicon oxide, Si partially or fully covered with silicon nitride, Si partially or fully covered with SiC.

The sensing module comprises at least one nanowire 3. A nanowire is an elongated structure of a cyrstalline or polycrystalline (semi)conducting material having a diameter typically less than 100 nm. A nanowire can for example be made of the following materials: group IV elements such as Si, Ge, etc., and combinations thereoef, alloys of group III/V elements such as InAs, GaAs, InP, GaP, GaN, and combinations thereof, alloys of group II/VI elements such as ZnS, ZnSe, CdS. CdSe and combinations thereof, metaloxides such as ZnO, In₂O₃, W₂O₃, and combinations thereof. The nanowires can be made with methods such as VLS (Vapour Liquid Solid) growth, direct etching or any other method known in the field.

Furthermore doping of part of the nanowire or the whole nanowire can be done. For example the bottom 3a and top 3c of each nanowire can be doped in order to realise a good Ohmic contact to the electrical connections 8, 10 towards the nanowire measurement pads 6, 9. Doping of the intermediate part 3b can modify the sensing performance of the device.

The nanowires are located on the substrate. In preferred embodiments they can be essentially perpendicular to the substrate (i.e. having their longitudinal direction substantially orthogonal to the substrate surface), but they can also make an angle different from 90° with the substrate. The angle with the substrate (i.e. the angle between the longitudinal direction of the nanowires and the surface plane of the substrate) can vary between 45° and 90°, or between 60° and 90°, or between 70° and 90°, or between 80° and 90°. Preferably the plurality of nanowires within a sensing module have essentially the same angle with the substrate, but different angles with the substrate for the different nanowires is possible. The nanowires do not touch the surrounding electrodes.

The surrounding electrode 4 is preferably made of an electrically conductive material, such as for example Au, Cr, Pt, Cu, Ti, Ta, Ru, Ni, Ge, Al, Mo, conducting Si and combinations thereof. Also a stack of conducting materials or metals can be used. Additional layers can be present underneath the conducting material or metal, for example to improve adhesion of the conducting layers or to avoid diffusion of the conducting material in other layers. For example, first a 10 nm to 40 nm thin Cr layer can be provided and next a Au layer can be provided as a conducting material for forming the surrounding electrode 4. The thickness of the Au layer can for example be in the order of 150 nm on the top of the nanowires and in the order of 75 nm at the sidewalls (vertically oriented surfaces) of the nanowires.

The surrounding electrode 4 may partially surround the nanowire 3 in height (i.e. in the longitudinal direction of the nanowire). For example, only the bottom 3a and part of the intermediate part 3b may be surrounded by the surrounding electrode 4. This is for example illustrated in Figures 1, 2(a), 3 and Figures 5(c) and 5(d). Alternatively, the bottom 3a and the full intermediate part 3b may be surrounded (as illustrated in Figure 6). In embodiments wherein a top electrical connection 10 is provided to the top 3c of the nanowire, the surrounding electrode 4 preferably surrounds the nanowire 3 only partially, i.e. preferably the top 3c of the nanowire is free in order to provide space for fabricating an electrode 10 to the top of the nanowire, and the upper part of the intermediate part 3b is free to facilitate the penetration of gasses in the gap. The height of the surrounding electrode can for example be in the range between 50 nm and 10 µm or between 80nm and 5 µm, preferably between 100 nm and 2 µm.

The nanowire can be located close to one part of the surrounding electrode and farther away from other parts, but preferably the nanowire is located in the center of the surrounding electrode. Preferably the distance between the nanowire and the electrode is similar at all locations of the electrode.

The surrounding electrode can have different geometries. A cross section through the surrounding electrode parallel to the substrate can have a circular shape, an oval shape, a polygon shape or any other suitable shape known to a person skilled in the art. In preferred embodiments the shape of this cross section is essentially circular. A good choice is a circular electrode that fully surrounds the bottom 3a and part of the intermediate part 3b whereby the nanowire is located in the centre of the circular electrode. The nanowire is preferably perpendicular to the substrate.

The surrounding electrodes 4 are electrically isolated from the nanowires, by providing a gap 5 between the nanowires 3 and the surrounding electrodes 4 and by providing an electrically insulating layer 2 between the electrical connections 8 to the nanowire and the electrical connections 11 to the surrounding electrode. An insulating layer 2 or region can also be provided under the nanowires 3.

The distance between a nanowire 3 and its surrounding electrode 4 can be optimised. Functionalization of the nanowire outer surface and/or the inner surface of the surrounding electrode may become difficult when the gap 5 is small. Typically the thickness of the functional layer may be that of one macromolecule, being about 5 nm. So preferably the gap is wider than 10 nm. Furthermore when the gap is small, it may become more difficult for the analyte to enter into the gap. On the other hand, the effect of a voltage applied to the electrode will be strongly reduced when the gap is broader, requiring higher voltages. The space between a nanowire and the surrounding electrode can be tuned during fabrication and can vary between 5nm and 500 nm, or preferably between 10 and 100 nm.

Figure 3 schematically illustrates different configurations that may be used to realise bottom electrical connections 8 to the bottom 3a of the nanowire 3 and second electrical connections 11 to the surrounding electrode 4 such that the nanowire 3 with its electrical connections and the surrounding electrode 4 with its electrical connections are electrically isolated from each other. Therefore an insulating layer 2 underneath the surrounding electrode 4 can be fabricated. The insulating layer 2 may for example comprise or consist of silicon nitride, SiO₂, HfO₂, ZrO₂, .... The nanowire 3 can penetrate through the insulating layer 2 down to a conducting substrate 1 (Figure 3(a)) or down to a conducting layer forming the bottom electrical connection 8 (Figures 3(b) and (c)). Altenatively, the conducting layer forming the bottom electrical connection 8 can penetrate through the insulating layer 2 as illustrated in Figures 1(a) and 1(c). The conducting layer forming the bottom electrical connection 8 or the substrate 1 can be electrically contacted directly or via a contact pad (bottom nanowire measurement pad 6). The nanowire can also contact a conducting area of the bottom electrical connection 8 that penetrates the insulating region (as illustrated in Figure 1(a)). The insulating layer 2 provides an electrical insulation between the conductive substrate 1 (Figure 3(a)) or the conductive region forming the bottom electrical connection 8 (Figures 3(b) and 3(c)) and the surrounding electrodes 4 and their contact pad 7.

A method that may be used for fabricating sensing elements according to the present invention is schematically illustrated in Figure 4. The order of the steps can be changed and/or different steps can be added or removed.

The fabrication of nanowires 3 with a surrounding electrode 4 and with a gap 5 between each nanowire 3 and the corresponding surrounding electrode 4 is illustrated in Figure 4(a) to Figure 4(i). The insulating layer 2 may be used to form the gap 5 between a nanowire 3 and its surrounding electrode 4. For example, the gap 5 can be fabricated by forming the nanowire 3, providing an insulating layer 2 on the nanowire surface, forming the surrounding electrode 4 on that insulating layer 2, and afterwards removing the insulating layer 2 in the region between the nanowire and the surrounding electrode. For this purpose, the insulating layer 2 is deposited as a layer covering the nanowires 3. After fabrication of the surrounding electrode 4, the part of the insulating layer 2 between the surrounding electrode 4 and the nanowires 3 is removed, thereby forming the gap 5 between the surrounding electrode 4 and the nanowires 3.

In a first step, nanowires 3 can be grown on the substrate 1 (Fig. 4(a)). The position of the nanowires may for example be controlled by patterning of catalyst particles before growth, or by any other suitable patterning method. Alternatively, nanowires may be patterned after growth by etching using an appropiate masking method. Next an electrically insulating layer or dielectric layer 2 can be provided on the substrate and the nanowires (Fig. 4(b)). The insulating layer is also deposited at the sidewalls (vertical surfaces) of the nanowires. Preferably the insulating layer is deposited conformally. Growth of the insulating layer (for example silicon nitride) can be done with PECVD. The insulating layer can be patterned, for example by etching holes in the insulating layer on the substrate (Fig. 4(c)), e.g. at locations where a bottom nanowire measurement pad 6 is to be formed in a later stage of the process. Then the electrically conductive material for forming measurement pads 6, 7, 9, second electrical connections 11 and for forming the surrounding electrodes 4 can be provided, such that it also covers the insulating layer 2 that is present on the sidewalls of the nanowires 3. Preferably the deposition is conformal. In a next step the electrode material can be patterned (Fig. 4(d)), such as to realise the nanowire measurement pads or contact pads 6, 9 for electrical connection to the nanowire 3 and the surrounding electrode measurement pad or contact pad 7 for electrical connection to the surrounding electrode 4. Patterning of the electrode material can also be done at a later stage (as further described). In this stage of the process, the insulating layer 2 at the sidewalls of the nanowires is electrically insulating the nanowires 3 from the surrounding electrode 4 and the insulating layer 2 is also electrically insulating the second electrical connection 11 and the surrounding electrode measurement pad or contact pad 7 and the top nanowire measurement pad 9 from the substrate 1.

Next a first resist layer 12 can be provided, partially embedding the nanowires 3 (Fig. 4(f)). Alternatively the first resist layer 12 can be provided such that it is fully embedding the nanowires (Fig. 4(e)) and afterwards the resist layer 12 can be etched back from the top to the target height of the surrounding electrodes 4 (Fig. 4(f)), i.e. till the remaining thickness of the first resist layer 12 corresponds to the predetermined height of the surrounding electrodes 4 in the final device. The surrounding electrode material can be etched to the height of the first resist layer 12 (Fig. 4(g)). Also the dielectric or insulating layer 2 can be etched to the same height (Fig. 4(h)). In other words, the insulating layer 2 can be etched to the height of the surrounding electrode 4. Patterning of the contact pads 6, 7, 9 (Fig. 4(d)) can also be done at this stage (as an alternative to patterning these pads as illustrated in Fig. 4(d), before providing the first resist layer 12). Thereto the first resist layer 12 can be patterned in the shape of the surrounding electrode measurement pad or contact pad 7 and/or the nanowire measurement pads 6, 9 and the surrounding electrode measurement pad 7 and/or the nanowire measurement pads 6, 9 can be formed by etching. At this stage of the process the top of the nanowires is exposed and the first resist layer 12 can be removed (Fig. 4(i)).

To enable measurement of the current through the nanowires 3, two contacts, preferably at the top 3c and the bottom 3a of the nanowire can be provided. Different possibilities to realise the bottom electrode or bottom electrical connection 8 are illustrated in Figure 3 and described above. The top 3c of the nanowires 3 can be electrically connected to the top nanowire measurement pad 9 by an airbridge construction (as sown in Figures 1(b), 1(c), 2(b), 2(c)) . A possible fabrication method of the top electrode or top electrical connection 10 is illustrated in Figures 4(j) to 4(o). A second resist layer 13 can be provided such that the nanowires 3 are fully embedded by this second resist layer (Fig. 4(j)). The second resist layer 13 is patterned to form an island embedding the nanowire array on which a top electrode 10 is to be formed in a later stage of the process (Fig. 4(k)). The second resist layer 13 is then further etched back such that the top 3c of the nanowires 3 is exposed (Fig. 4(l)) to be able to contact the top 3c of the nanowires with a top electrode 10 in a later stage of the process. In the next step, the electrode material for forming the top electrode 10 can be deposited and patterned, for example using a third resist layer (not illustrated) acting as a mask for patterning (Fig. 4(m)). The second resist layer 13 can then be removed and an airbridge (forming the top electrode 10) can be realised (Fig. 4(n)). Finally the dielectric layer or insulating layer 2 between the nanowires 3 and surrounding electrodes 4 can be removed (Fig. 4(o)) to realise the gap 5 between the nanowires 3 and their surrounding electrode 4. This can for example be done by plasma etching.

Functionalization of the nanowire (outer) surface and/or the inner surface of the surrounding electrode 4 (i.e. the surface of the surrounding electrode that is facing the nanowire outer durface) is done to enable capturing of particular analytes. The inner surface of the surrounding electrode 4 and the outer surface of the nanowire 3 can for example be functionalized separately by different binding chemistries. The inner surface of the surrounding electrode 4 may for example consist of gold, enabling binding using thiol linkers. The outer surface of the nanowire 3 may for example be oxidized, enabling binding using carbohydroxilic linkers. Adhesion layers can be realised on the outer surface of the nanowire 3 and/or on the inner surface of the surrounding electrode 4, for example for functional ization with specific classes of molecules. Also passivation layers can be used to passivate the nanowire surface (e.g. the native oxide of the nanowire material). Different functional molecules can be used for example to increase the selectivity of the device. One particular functionalization can be selected to sense a particular analyte. Two different functionalizations can be used on the nanowire surfaces and the inner electrode surfaces, each functionalization being selected to sense the same or a different analyte. Different functionalisations can be used for the different sensing modules each being sensitive to a particular analyte. This allows detecting different analytes and the composition of the analytic environment can be defined.

Functionalizing the nanowire can be done using thiols linkers, carbohydroxilic acid linkers, amine-based linkers, or other self-assembly processes. Functionalizing the nanowire can be done with inorganic materials, such as metaloxides (for example ZnO, W₂O₃) and metals (for example Pd, Au). Examples of molecules that can be used for functionalization are (metal)porphyrins and (metal)phthalocyanines polymers etc or any complexing, chelating functionality, or inorganic thin layers, such as metaloxides, metals, molecules that can be used to detect electrondonating or -accepting gases such as NO₂, NH₃, O₂, CO, O₃, SO₂. Other functionalizations may be antibodies, enzymes, proteins or any other biomolecule.

The functionalization can for example be done by dipping the fabricated devices in a solution containing the linker molecules for a time long enough for binding of the molecules to occur. The device is then rinsed and dipped in a solution containing the sensing molecules, for a time sufficient for binding of the sensing molecules to occur. The device is then rinsed again. Alternatively, functionalization may be done using (molecular) ALD deposition, evaporation, spincoating and other methods known in the field. Functionalization can be done at the end of the device fabrication process or it may be done during the device fabrication process, depending on the nature of the functionalization layer.

A device according to the present invention allows the penetration of an analyte into the gap 5 between the nanowire 3 and the surrounding electrode 4, and allows double functionalization of the device on two distinctly different surfaces, i.e. the nanowire surface and the inner surface of the surrounding electrode. Functionalization of these surfaces provides binding sites for the analyte, enabling the selective detection of the analyte.

The detection mechanism of the device can be based on different phenomena.

An analyte penetrating in the gap 5 between a nanowire 3 and the corresponding surrounding electrode 4 may directly change the capacitive coupling between the nanowire 3 and the surrounding electrode 4 due to the presence of the analyte in the gap 5 or due to charge/energy transfer from the analyte to the nanowire 3 and/or the surrounding electrode 4.

Adsorption or absorption of the analyte on/in the functional layer on the nanowire surface and/or inner surface of the surrounding electrode may change the capacitive coupling between the nanowire 3 and the surrounding electrode 4 by changing the dielectric properties of the functional layer, charging of the functional layer, formation of dipoles on/in the functional layer, or swelling of the functional layer, and charge/energy transfer from the analyte to the functional layer or to the nanowire and/or the surrounding electrode.

For example by using functionalization of the nanowire surface and/or the inner surface of the surrounding electrode 4 with redox-active molecules, charges and/or dipoles can be formed upon selective analyte binding of charge withdrawing or charge donating analytes, resulting in a change of the capacitive coupling between the nanowire 3 and the surrounding electrode 4.

The change in capacitive coupling between the nanowire 3 and the surrounding electrode 4 may be measured directly, or its effect on the current through the nanowire may be measured.

Alternatively, irrespective of any change in the capacitive coupling between the nanowire 3 and the surrounding electrode 4, the effect on the electrical properties of the nanowire 3 by analyte adsorption on the bare/functionalized nanowire surface may be detected by measuring the current through the nanowire 3. If the device only comprises top electrodes 10 and no bottom electrodes 8, a voltage can be applied between the top electrodes 10 of different nanowires or nanowire arrays and the current between both top electrodes 10 can be measured. If both top electrodes 10 and bottom electrodes 8 are provided, a voltage can be applied between the top electrode 10 and the bottom electrode 8 of one nanowire or nanowire array and the current between the top electrode 10 and the bottom electrode 8 can be measured.

To determine the analyte concentration and/or composition different measurements can be done, such as capacitive measurement between the surrounding electrode and the nanowire, or a measurement of the current through the nanowire. In the latter case, in a preferred embodiment, the surrounding electrode 4 can be used as a transistor gate and the electrical connections (bottom electrode 8 and top electrode 10) on the nanowire 3 can act as a transistor source and drain respectively.

For capactive measurements, the nanowire 3 can be used as a first electrode and the surrounding electrode 4 can be used as a second electrode. The charge on the surrounding electrode 4 and nanowire 3 when applying a voltage between the surrounding electrode and nanowire (i.e. capacitance) depends on the dielectric properties of the gap 5 between the nanowire (first electrode) and the surrounding electrode (second electrode). The gap 5 between the nanowire 3 and the surrounding electrode 4 can for example comprise an airgap and the functional layers on the nanowire surface and/or electrode inner surface. If the dielectric properties of these functional layers change, e.g. by dipole formation due to analyte adsorption, the capacitance may change. This change in capacitance can be measured by an external circuit. The change in capacitance can depend on the amount of dipoles formed between the nanowire and the surrounding electrode, which in turn depends on analyte concentration and the particular combination of analyte and sensing molecule.

A method for measuring the capacitance can be the following. An AC voltage can be applied between the nanowire 3 and the surrounding electrode 4 The applied AC voltage can vary between -10 and +10 V, but varies preferably between -1 and +1 V, but other voltages are possible. The frequency can be between 4 Hz and 1 GHz, but preferably between 100 Hz and 100MHz, but other frequencies can be used.

Preferably the gap 5 between the nanowires 3 and the surrounding electrodes 4 is as small as possible. A change in electric potential between 0 and 0.9 V can be expected for example, in the case of an analyte concentration of 20 ppm.

Another option is to measure the change in electric potential by measuring the electrical current through the nanowire 3 when applying a voltage to the surrounding electrode 4. To measure the current in the nanowire, at least two contacts on the nanowire are needed, preferably at the top and the bottom of the nanowire. In that case, the device can be measured as a transistor, wherein the two electrodes on the nanowire 3 (bottom electrode 8 and top electrode 10) act as a source and a drain respectively and wherein the surrounding electrode 4 acts as a gate. The top 3c of the nanowire 3 can for example be connected to top electrode 10 acting as a drain, and the bottom 3a of the nanowire 3 can for example be connected to the substrate 1 acting as the source. When three electrodes are used as a gate, a source and a drain respectively, the change in the current flowing between source and drain (i.e. through the nanowire) can be measured for a certain gate voltage. The gate voltage regulates the current flowing through the nanowire like in a conventional field effect transistor, by capacitive coupling to the electrons in the channel (i.e.nanowire). For example, when the gate is charged negatively (by applying a negative voltage on it), electrons in the nanowire are repelled, leading to a reduced source-drain current. The capacitive coupling depends on the dielectric properties of the gap 5 between the gate (surrounding electrode 4) and the nanowire 3, so the current flowing through the nanowire for a given gate voltage is affected e.g. by dipole formation due to analyte absorption between the gate (surrounding electrode 4) and the nanowire 3. Besides the capacitance between the gate and the nanowire surface, there is also a capacitance between the surface of the nanowire and the inside of the nanowire. This region exists due to the accumulation or depletion of electrons near the surface of the nanowire due to the external field (by the applied voltage between gate and nanowire).

The voltage applied between the source and the drain (so between the top electrode 10 and the bottom electrode 8 of the nanowire) is preferably between 0V and 10V. Without applying a voltage on the surrounding electrode a current of a few microamperes is expected for a single nanowire using a source-drain voltage of about 1V. When applying a voltage on the surrounding electrode a change in the current up to 100% can be expected, so the resulting current can be be in the range of 0 to several microamperes. Generally, the voltage on the surrounding electrode is chosen such that variations in the current upon the analyte absorption are maximized. The voltage change needed on the surrounding electrode to counteract the effect of the analyte absorption on the current may then be used to quantify the analyte concentration by calibration.

As an alternative to capacitive measurements, the discharge current can be measured upon applying a DC voltage between the nanowire 3 and the surrounding electrode 4. For example, first the device can be charged by applying a DC voltage to the surrounding electrode 4, the nanowire 3 being grounded, or by applying a DC voltage difference between the surrounding electrode 4 and the nanowire 3. Then the source of the DC voltage (difference) is removed and the discharging of the device is measured based on the current flowing in the external circuit during discharging, The current flow during the discharge is proportional to the charge accumulated on the surrounding electrode and depends on the capacitance between the nanowire and the surrounding electrode. The voltage applied on the surrounding electrode (the nanowire being grounded) or the voltage difference between the nanowire and the surrounding electrode can be between -100V and +100V, but is preferably between -10 and +10V.

### Experimental example I

Nanowires were made of InAs and surrounded by a Au electrode (Figure 5) according to the procedure presented in Figure 4. The nanowires were prepared as follows: a 1.5 nm layer of SiO was evaporated on an InP (111) substrate covered with an epiready oxide. Nanowires were grown without a catalyst on this substrate in a MOCVD reactor at 600°C, using trimethylindium as a precursor in an As environment. For a growth time of 1.5 min, the length of the nanowires is about 3 micrometer with a diameter of 50-100 nm. The nanowires were patterned in arrays with a PECVD Si₃N₄ layer as a hard mask using piranha etching (Figure 5(a)).

The surrounding electrodes were prepared as follows: 150 nm of Si₃N₄ was deposited on the nanowires using PECVD. Then 40 nm Cr and 150 nm Au were sputtered, conformally covering the nanowires. The structures were embedded in a resist which was patterned to the shape of the surrounding electrode measurement pad 7 and subsequently used as a mask for wet chemical etching of Au/Cr, leaving the surrounding electrode measurement pad 7 and the surrounding electrodes 4 (Figure 5b).

The height of the surrounding electrodes 4, initially covering the nanowires, was adjusted in a similar way, by back etching the embedding resist to the height of the resulting electrode, using it as a mask for wet chemical etching of the gold and the chromium. Then the resist was removed. The height of the surrounding electrode is about 800 nm with a wall thickness of about 50 nm (Figure 5c). The Si₃N₄ between the nanowires and the electrode was removed by an HF dip (Figure 5d).

### Experimental example II

Nanowires were made of InAs and surrounded by a Au electrode (see Figure 6) using the method described above but the height of the surrounding electrodes was close to the height of the nanowires. The Si₃N₄ between the nanowires and the surrounding electrode was removed by dry etching.

### Experimental example III

To make the device sensitive to NO₂, the nanowire was functionalised with a tetraphenylporphyrin based molecule. Depending on the chemistry the molecules may be attached to the nanowire surface or to the inner surface of the surrounding electrode. To functionalize the gold electrode, first a monolayer of linker molecules having one thiol end group and one amine end group are attached to the gold electrode by self-assembly. Then, these molecules are used to attach tetraphenylporphyrin having a carbohydroxylic group.

The nanowires surface may be directly functionalized by making use of its native oxide to which tetraphenylporphyrin having a carbohydroxylic group adheres directly. Alternatively, the native oxide may be removed, and thiol-based linker molecules can be used to assemble the tetraphenylporphyrins on the surface.

### Experimental example IV

The gas sensing modules can be used to measure analyte concentration by measuring the nanowire current and comparing this to that obtained from calibration using a known analyte concentration. Alternatively, instead of the nanowires current, the voltage needed on the surrounding electrode to retrieve the current before exposure may be used as the measured variable.

### Experimental example V

The gas sensing modules can be used to measure analyte concentration by measuring the change in device capacitance by applying an AC voltage between nanowire measurement pad 6 and the surrounding electrode measurement pad 7. The change in capacitance is compared to that obtained during calibration with a known analyte concentration.

### Experimental example VI

InAs nanowires were grown vertically using a 1.2 nm silicon oxide nucleation layer. Although the nucleation mechanism is not exactly known, defects in the silicon oxide layer may acts as nucleation sites. The nanowires were grown to a length (height) of about 3 µm with a diameter varying from 50 nm to 100 nm. After nanowire growth, the nanowires were patterned into arrays using a piranha etch with a 80 nm thick patterned silicon nitride layer acting as a mask. The silicon nitride was removed after nanowire patterning. A SEM photograph of a patterned vertical nanowire array thus obtained is shown in Figure 7(a).

Electrical connections were made to the vertical nanowires by an airbridge construction. First a 80 nm thick layer of silicon nitride was deposited. This silicon nitride layer acts as a substrate isolation layer and was also deposited on the nanowire surface. Then the nanowires were embedded in a resist, which was etched back using an oxygen plasma, to a height of about 2.4 µm. The silicon nitride covering the top of the nanowires was removed using a CF4 plasma after which the resist was removed. Figure 7(b) is a SEM photograph showing the structure obtained, wherein nanowires are partially embedded in the silicon nitride.

As a support for the top contact, the nanowires were embedded in a resist which was patterned to form islands embedding the nanowire arrays. The resist islands were etched back to a height of about 2 µm. After a BHF etch, contacts (top electrodes) were made by sputter deposition of 10 nm Ti followed by 1 µm of gold. Subsequently, the contacts (top electrodes) were patterned into an airbridge by wet chemical etching. A top view of the resulting structure is shown in Figure 7(c).

Finally, all remaining resist was removed and the structures were dried by transferring from warm isopropanol to isopropanol vapor, leading to freestanding airbridges that vertically connect the nanowire arrays, as illustrated in Figure 7(d) and Figure 7(e). The airbridges are freestanding and connect the top of the different nanowires. The bottom of the nanowires is still covered with a 80 nm thick layer of silicon nitride.

The current-voltage characteristics of the vertically connected nanowire arrays were measured by probing a pair of arrays on their top contacts. As illustrated by the measurement results shown in Figure 8(a), the current increases linearly as a function of applied voltage, indicating Ohmic contacts. As illustrated in Figure 8(b), at a given voltage the current scales linearly with the contacted area and thus with the number of nanowires in the arrays. The noise spectrum of vertically connected nanowire arrays was determined using a dynamic signal analyzer in the frequency range of 0.7 - 1.600 kHz. The nanowire arrays show a 1/f behavior (Figure 8(c)). From the noise spectrum it can be determined that the obtainable resolution of a resistance measurement of the nanowire array is around 0.1 %.

The gas sensing properties of vertically connected InAs nanowires have been investigated for NO₂ in a N₂ environment using a probe station with gas flow capability. Prior to the gas measurements the silicon nitride covering the nanowires (Figure 7(e)) was removed using a CF₄ plasma. Figure 9(a) shows the response to NO₂/N₂ measured in the concentration range from 115 ppb to 1.7 ppm. The current was measured between pairs of nanowire arrays comprising about 200 nanowires each. Exposure time was limited to 1 hour. During this time, the current decreases upon NO₂ exposure. Between each exposure the chamber was flushed with pure nitrogen during which the current increases. At these low concentrations, saturation could not be reached within 1 hour of NO₂ exposure. The response to NO₂ as function of concentration using 1 hour exposure intervals is nonlinear, as illustrated in Figure 9(b).

## Claims

1. An analyte sensing device comprising at least one sensing module on a substrate (1) wherein each module comprises:
- at least one nanowire (3), each nanowire comprising a bottom (3a), an intermediate part (3b) and a top (3c), the bottom (3a) being closer to the substrate (1) than the top (3c);
- a surrounding electrode (4) for each nanowire, the surrounding electrode surrounding the bottom (3a) and at least part of the intermediate part (3b) of the nanowire (3) in height direction, each surrounding electrode being electrically isolated from the respective nanowire;
**characterised in that** each module comprises a gap (5) between each nanowire (3) and the respective surrounding electrode (4) for allowing penetration of at least one analyte to be detected between the nanowire and the respective surrounding electrode; andmeasurement circuitry electrically connected to each nanowire (3) and each surrounding electrode (4) for detecting a change in capacitive coupling between the at least one nanowire and the corresponding surrounding electrode as a result of said penetration of at least one analyte into said gap (5)
- wherein each surrounding electrode (4) has an inner surface facing an outer surface of the corresponding nanowire (3), wherein a functionalization layer is provided on at least one of said inner and outer surface for binding said at least one analyte to be detected, and wherein the measurement circuitry is provided for detecting a change in capacitive coupling between the at least one nanowire and the corresponding surrounding electrode as a result of said binding.

2. An analyte sensing device according to claim 1, wherein a functionalization layer is provided on both said inner and outer surfaces.

3. An analyte sensing device according to claim 2, wherein the functionalization layer on the outer surface is provided for binding a first analyte and wherein the functionalization layer on the inner surface is provided for binding a second analyte.

4. An analyte sensing device according to any of the previous claims, wherein said measurement circuitry comprises at least one nanowire measurement pad (6, 9) in electrical contact with the top and/or bottom of each nanowire (3).

5. An analyte sensing device according to any of the previous claims wherein said measurement circuitry comprises a surrounding electrode measurement pad (7) in electrical contact with each surrounding electrode (4).

6. An analyte sensing device according to any of the previous claims, wherein said measurement circuitry is provided for detecting a change in electric current through each nanowire (3) while the respective surrounding electrode (4) is operated as a transistor gate.

7. An analyte sensing device according to any one of the previous claims, wherein each surrounding electrode (4) is provided on an insulating region (2) of said substrate, providing said electrical isolation.

8. An analyte sensing device according to any one of the previous claims, comprising a plurality of sensing modules arranged in an array, each sensing module being electrically isolated from the other sensing modules.

9. An analyte sensing device according to any one of the previous claims, wherein each sensing module comprises a plurality of nanowires (3) being in electrical contact with each other.

10. An analyte sensing device according to any one of the previous claims, wherein the bottom (3a) and/or the top (3c) of each nanowire is doped, such as to realise an Ohmic contact with the measurement circuitry.

11. An analyte sensing device according to any one of the previous claims, wherein the intermediate part (3b) of the nanowires is doped in view of a desired sensing performance.

12. An analyte sensing device according to any of the previous claims wherein the at least one nanowire (3) has a longitudinal direction substantially orthogonal to the substrate surface.

## Patentansprüche

1. Vorrichtung zum Erkennen eines Analyten, die mindestens ein Sensormodul auf einem Substrat (1) umfasst, wobei jedes Modul umfasst:
- mindestens einen Nanodraht (3), wobei jeder Nanodraht eine Unterseite (3a), einen mittleren Teil (3b) und eine Oberseite (3c) umfasst, wobei die Unterseite (3a) näher an dem Substrat (1) als die Oberseite (3c) liegt;
- eine umgebende Elektrode (4) für jeden Nanodraht, wobei die umgebende Elektrode die Unterseite (3a) und mindestens einen Teil des mittleren Teils (3b) des Nanodrahts (3) in Richtung der Höhe umgibt, wobei jede umgebende Elektrode von dem jeweiligen Nanodraht elektrisch isoliert ist;
**dadurch gekennzeichnet, dass** jedes Modul einen Spalt (5) zwischen jedem Nanodraht (3) und der jeweiligen umgebenden Elektrode (4) umfasst, um eine Durchdringung des mindestens einen Analyten, der detektiert werden soll, zwischen dem Nanodraht und der jeweiligen umgebenden Elektrode zu ermöglichen; und einen Messschaltkreis umfasst, der elektrisch mit jedem Nanodraht (3) und jeder umgebenden Elektrode (4) verbunden ist, um eine Veränderung in der kapazitiven Kopplung zwischen dem mindestens einen Nanodraht und der entsprechenden umgebenden Elektrode als ein Ergebnis der Durchdringung des mindestens einen Analyten in dem Spalt (5) zu detektieren,
- wobei die umgebende Elektrode (4) eine innere Oberfläche, die einer äußeren Oberfläche des entsprechenden Nanodrahts (3) zugewandt ist, aufweist, wobei eine Funktionalisierungsschicht auf der inneren und/oder der äußeren Oberfläche bereitgestellt ist, um mindestens einen Analyten, der detektiert werden soll, zu binden, und wobei der Messschaltkreis bereitgestellt ist, um eine Veränderung in der kapazitiven Kopplung zwischen dem mindestens einen Nanodraht und der entsprechenden umgebenden Elektrode als ein Ergebnis der Bindung zu detektieren.

2. Vorrichtung zum Erkennen eines Analyten nach Anspruch 1, wobei eine Funktionalisierungsschicht sowohl auf der inneren als auch auf der äußeren Oberfläche bereitgestellt ist.

3. Vorrichtung zum Erkennen eines Analyten nach Anspruch 2, wobei die Funktionalisierungsschicht auf der äußeren Oberfläche bereitgestellt ist, um einen ersten Analyten zu binden, und wobei die Funktionalisierungsschicht auf der inneren Oberfläche bereitgestellt ist, um einen zweiten Analyten zu binden.

4. Vorrichtung zum Erkennen eines Analyten nach einem der vorhergehenden Ansprüche, wobei der Messschaltkreis mindestens ein Nanodrahtmesskissen (6, 9) in einem elektrischen Kontakt mit der Oberseite und/oder der Unterseite jedes Nanodrahts (3) umfasst.

5. Vorrichtung zum Erkennen eines Analyten nach einem der vorhergehenden Ansprüche, wobei der Messschaltkreis ein Messkissen (7) einer umgebenden Elektrode in einem elektrischen Kontakt mit jeder umgebenden Elektrode (4) umfasst.

6. Vorrichtung zum Erkennen eines Analyten nach einem der vorhergehenden Ansprüche, wobei der Messschaltkreis bereitgestellt ist, um eine Veränderung in dem elektrischen Strom durch jeden Nanodraht (3) zu detektieren, währen die jeweilige umgebende Elektrode (4) als ein Transistor-Gate betrieben wird.

7. Vorrichtung zum Erkennen eines Analyten nach einem der vorhergehenden Ansprüche, wobei jede umgebende Elektrode (4) auf einem isolierenden Bereich (2) des Substrats, der die elektrische Isolation bereitstellt, bereitgestellt ist.

8. Vorrichtung zum Erkennen eines Analyten nach einem der vorhergehenden Ansprüche, die mehrere Sensormodule, die in einer Gruppe angeordnet sind, umfasst, wobei jedes Sensormodul von den anderen Sensormodulen elektrisch isoliert ist.

9. Vorrichtung zum Erkennen eines Analyten nach einem der vorhergehenden Ansprüche, wobei jedes Sensormodul mehrere Nanodrähte (3) umfasst, die miteinander in einem elektrischen Kontakt stehen.

10. Vorrichtung zum Erkennen eines Analyten nach einem der vorhergehenden Ansprüche, wobei die Unterseite (3a) und/oder die Oberseite (3c) eines jeden Nanodrahts dotiert ist, um einen Ohmschen Kontakt mit dem Messschaltkreis zu realisieren.

11. Vorrichtung zum Erkennen eines Analyten nach einem der vorhergehenden Ansprüche, wobei der mittlere Teil (3b) der Nanodrähte im Hinblick auf eine gewünschte sensorische Leistungseigenschaft dotiert ist.

12. Vorrichtung zum Erkennen eines Analyten nach einem der vorhergehenden Ansprüche, wobei der mindestens eine Nanodraht (3) eine Längsrichtung aufweist, die im Wesentlichen senkrecht zu der Substratoberfläche ist.

## Revendications

1. Dispositif de détection d'analyte comprenant au moins un module de détection sur un substrat (1), dans lequel chaque module comprend :
- au moins un nanofil (3), chaque nanofil comprenant un dessous (3a), une partie intermédiaire (3b) et un dessus (3c), le dessous (3a) étant plus proche du substrat (1) que le dessus (3c) ;
- une électrode encerclante (4) pour chaque nanofil, l'électrode encerclante encerclant le dessous (3a) et au moins une partie de la partie intermédiaire (3b) du nanofil (3) dans le sens de la hauteur, chaque électrode encerclante étant électriquement isolée du nanofil concerné ;
**caractérisé en ce que** chaque module comprend un espace (5) entre chaque nanofil (3) et l'électrode encerclante (4) concernée pour permettre la pénétration d'au moins un analyte à détecter entre le nanofil et l'électrode encerclante concernée ; et une circuiterie de mesure électriquement connectée à chaque nanofil (3) et chaque électrode encerclante (4) pour détecter un changement du couplage capacitif entre le au moins un nanofil et l'électrode encerclante correspondante résultant de ladite pénétration d'au moins un analyte dans ledit espace (5)
- dans lequel chaque électrode encerclante (4) a une surface intérieure faisant face à une surface extérieure du nanofil (3) correspondant, dans lequel une couche de fonctionnalisation est prévue sur au moins une desdites surfaces intérieure et extérieure pour lier ledit au moins un analyte à détecter, et dans lequel la circuiterie de mesure est prévue pour détecter un changement du couplage capacitif entre le au moins un nanofil et l'électrode encerclante correspondante résultant de ladite liaison.

2. Dispositif de détection d'analyte selon la revendication 1, dans lequel une couche de fonctionnalisation est prévue sur lesdites deux surfaces intérieure et extérieure.

3. Dispositif de détection d'analyte selon la revendication 2, dans lequel la couche de fonctionnalisation sur la couche extérieure est prévue pour lier un premier analyte et dans lequel la couche de fonctionnalisation sur la surface intérieure est prévue pour lier un deuxième analyte.

4. Dispositif de détection d'analyte selon l'une quelconque des revendications précédentes, dans lequel ladite circuiterie de mesure comprend au moins un tampon de mesure (6, 9) de nanofil en contact électrique avec le dessus et/ou le dessous de chaque nanofil (3).

5. Dispositif de détection d'analyte selon l'une quelconque des revendications précédentes, dans lequel ladite circuiterie de mesure comprend un tampon de mesure (7) d'électrode encerclante en contact électrique avec chaque électrode encerclante (4)

6. Dispositif de détection d'analyte selon l'une quelconque des revendications précédentes, dans lequel ladite circuiterie de mesure est prévue pour détecter un changement du courant électrique passant par chaque nanofil (3) tandis que l'électrode encerclante (4) concernée est utilisée comme une grille de transistor.

7. Dispositif de détection d'analyte selon l'une quelconque des revendications précédentes, dans lequel chaque électrode encerclante (4) est prévue sur une région isolante (2) dudit substrat, fournissant ladite isolation électrique.

8. Dispositif de détection d'analyte selon l'une quelconque des revendications précédentes, comprenant une pluralité de modules de détection agencés en une matrice, chaque module de détection étant électriquement isolé des autres modules de détection.

9. Dispositif de détection d'analyte selon l'une quelconque des revendications précédentes, dans lequel chaque module de détection comprend une pluralité de nanofils (3) en contact électrique les uns avec les autres.

10. Dispositif de détection d'analyte selon l'une quelconque des revendications précédentes, dans lequel le dessous (3a) et/ou le dessus (3c) de chaque nanofil est dopé, de manière à réaliser un contact ohmique avec la circuiterie de mesure.

11. Dispositif de détection d'analyte selon l'une quelconque des revendications précédentes, dans lequel la partie intermédiaire (3b) des nanofils est dopée en vue d'une performance de détection souhaitée.

12. Dispositif de détection d'analyte selon l'une quelconque des revendications précédentes, dans lequel le au moins un nanofil (3) a une direction longitudinale pratiquement orthogonale à la surface du substrat.
